Europäisches Patentamt

European Patent Office

Office européen des brevets

(19)

(11) Numéro de publication: **0 209 178 B1**

(12) # FASCICULE DE BREVET EUROPEEN

(45) Date de publication de fascicule du brevet:
04.09.91

(51) Int. Cl.⁵: **H03C 1/06**, G01S 13/78, H03F 1/32

(21) Numéro de dépôt: 86201141.8

(22) Date de dépôt: 30.06.86

(54) Dispositif pour émettre des impulsions haute fréquence selon un certain gabarit et système de radionavigation comportant un tel dispositif.

(30) Priorité: 02.07.85 FR 8510061

(43) Date de publication de la demande:
21.01.87 Bulletin 87/04

(45) Mention de la délivrance du brevet:
04.09.91 Bulletin 91/36

(84) Etats contractants désignés:
DE FR GB IT

(56) Documents cités:
EP-A- 0 096 820
DE-B- 2 835 751

(73) Titulaire: TELECOMMUNICATIONS RADIOE-
LECTRIQUES ET TELEPHONIQUES T.R.T.
88, rue Brillat Savarin
F-75013 Paris(FR)

(84) Etats contractants désignés:
FR

Titulaire: N.V. Philips' Gloeilampenfabrieken
Groenewoudseweg 1
NL-5621 BA Eindhoven(NL)

(84) Etats contractants désignés:
DE GB IT

(72) Inventeur: Ehlinger, Dominique SOCIETE CIVI-
LE S.P.I.D.
209 rue de l'Université
F-75007 Paris(FR)
Inventeur: Susset, Jean-Pierre SOCIETE CIVI-
LE S.P.I.D.
209 rue de l'Université
F-75007 Paris(FR)

(74) Mandataire: **Chaffraix, Jean et al
Société Civile S.P.I.D. 156, Boulevard Haussmann
F-75008 Paris(FR)**

## Description

La présente invention concerne un dispositif pour émettre des impulsions haute fréquence selon un certain gabarit présentant une partie rectiligne, dispositif comportant un générateur de signal haute fréquence muni d'une entrée de commande de modulation pour fournir à sa sortie lesdites impulsions en fonction d'un signal de modulation appliqué à son entrée de modulation et un générateur de modulation pour fournir le signal de modulation à l'entrée de modulation, un circuit de réplique pour fournir une réplique de l'impulsion émise, un circuit de gestion pour comparer cette réplique avec ledit gabarit et pour modifier le signal de modulation du générateur de modulation, dans un sens tel que la réplique corresponde au gabarit, dont des valeurs sont emmagasinées dans une mémoire morte.

Pour pouvoir émettre des impulsions conformes à ce gabarit, il a été proposé dans le brevet EP-A-0 096 820 d'emmagasiner sous forme numérique dans une mémoire morte différentes valeurs représentant la totalité de l'enveloppe de l'impulsion et l'on effectue les corrections pour que l'impulsion émise corresponde à ces valeurs emmagasinées, ce qui représente un traitement important. De plus, ces corrections sont effectuées en tenant compte de paramètres de l'appareillage constituant le dispositif et de ce fait elles risquent d'être beaucoup moins efficaces si la valeur de ces paramètres évolue par suite de vieillissement, d'échauffement, etc...

La présente invention propose un dispositif du genre qui ne présente pas ces inconvénients, notamment de traitement important, tout en évitant la prise en compte des paramètres de l'appareillage.

Pour cela, un tel dispositif est remarquable en ce que ce circuit de gestion exécute différents traitements pour différentes parties de l'impulsion :
- un premier traitement consistant à déterminer une valeur de seuil pour obtenir une valeur à appliquer à l'entrée de modulation du générateur de signal haute fréquence telle que celui-ci commence à émettre son énergie,
- un deuxième traitement consistant à rendre rectiligne une partie de l'impulsion émise correspondant à la partie rectiligne du gabarit par des corrections successives et en tenant compte des fractions de la valeur crête fournie par un détecteur de crête prévu pour mesurer la crête de la réplique,
- un troisième traitement consistant à raccorder cette partie rectiligne avec le reste de l'impulsion en utilisant des valeurs emmagasinées dans la mémoire et en les corrigeant en fonction de la valeur de seuil,
- un quatrième traitement consistant à terminer l'impulsion de manière continue.

Ainsi la demanderesse s'est aperçue qu'il suffit d'apporter des corrections à la partie rectiligne la plus critique pour les mesures de radionavigation et qu'une approximation succincte pour la suite de l'impulsion permet de respecter les exigences imposées.

La description suivante faite en regard des dessins annexés, le tout donné à titre d'exemple non limitatif, fera bien comprendre comment l'invention peut être réalisée.

La figure 1 représente le dispositif conforme à l'invention.

La figure 2 représente le gabarit de l'enveloppe de l'impulsion à transmettre.

La figure 3 représente l'enchaînement dans le temps de différents sous-programmes régissant le fonctionnement du dispositif de la figure 1.

La figure 4 représente la phase d'initialisation d'un programme principal.

La figure 5 représente l'ordinogramme de la gestion des sous-programmes d'interruption.

La figure 6 représente l'ordinogramme de la gestion du sous-programme MTRA.

La figure 7 représente l'ordinogramme de la gestion du sous-programme MLD.

La figure 8 représente l'allure de la courbe de modulation obtenue par la mise en oeuvre du sous-programme MLD.

La figure 9 représente l'ordinogramme de la gestion du sous-programme MEMI.

La figure 10 représente l'ordinogramme de la gestion du sous-programme ESL faisant partie du sous-programme MTRA.

La figure 11 représente l'ordinogramme de la gestion du sous-programme EAP faisant partie du sous-programme MTRA.

Les figures 12a et 12b représentent les ordinogrammes de gestion du sous-programme ECO faisant partie du sous-programme MTRA.

La figure 13 représente l'ordinogramme de la gestion du sous-programme EAL faisant partie du sous-programme MTRA.

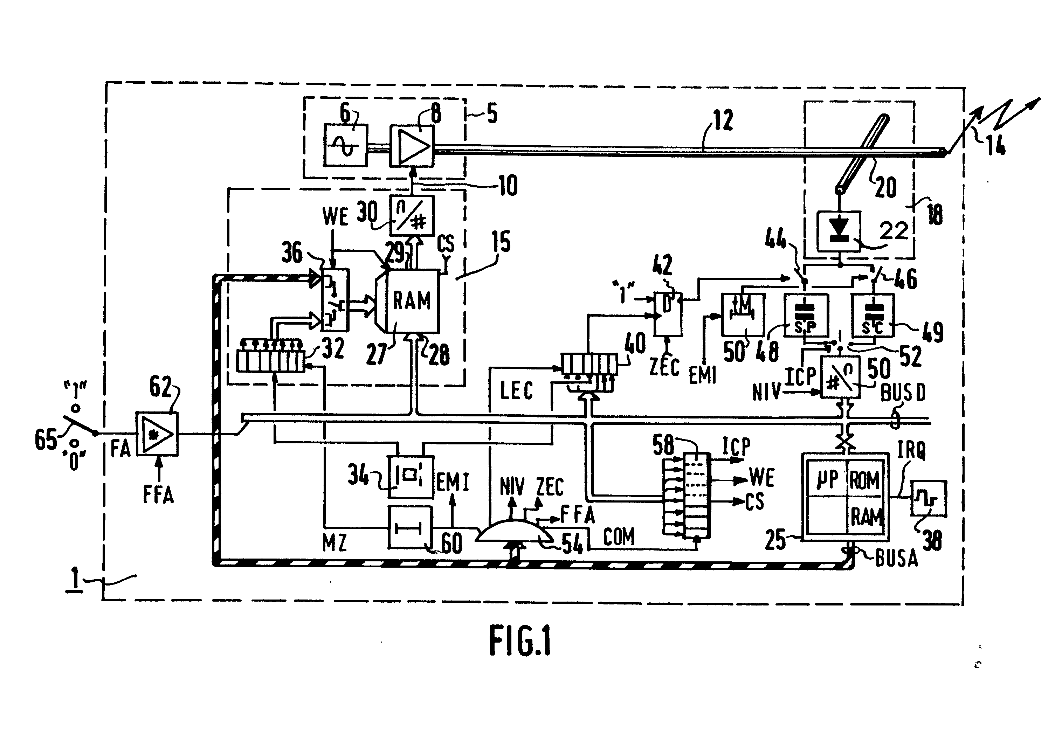

Le dispositif pour émettre des impulsions à haute fréquence porte à la figure 1 la référence 1, un générateur de signal à haute fréquence la référence 5. Ce générateur est formé d'un oscillateur 6 fournissant un signal continu à haute fréquence et d'un amplificateur à haute fréquence 8. Pour moduler le signal à la sortie de l'amplificateur 8, on agit sur la tension d'alimentation de l'amplificateur appliquée à son entrée 10. Cette entrée 10 constitue donc l'entrée de modulation du générateur 5. Cette technique de modulation est montrée dans le schéma "35-MHz 6-W NARROW-BAND A-M TRANSMITTER" de la page 887 de l'ouvrage ELECTRONIC CIRCUITS MANUAL de John MARKUS édité par Mc GRAW-HILL BOOK COMPANY. Il est bien évident que l'on peut extrappoler cette technique pour d'autres fréquences. La sortie de l'amplificateur qui constitue ainsi la sortie du générateur 5 est connectée via une ligne de transmission 12 à une antenne 14 pour que les impulsions émises soient transmises dans l'espace.

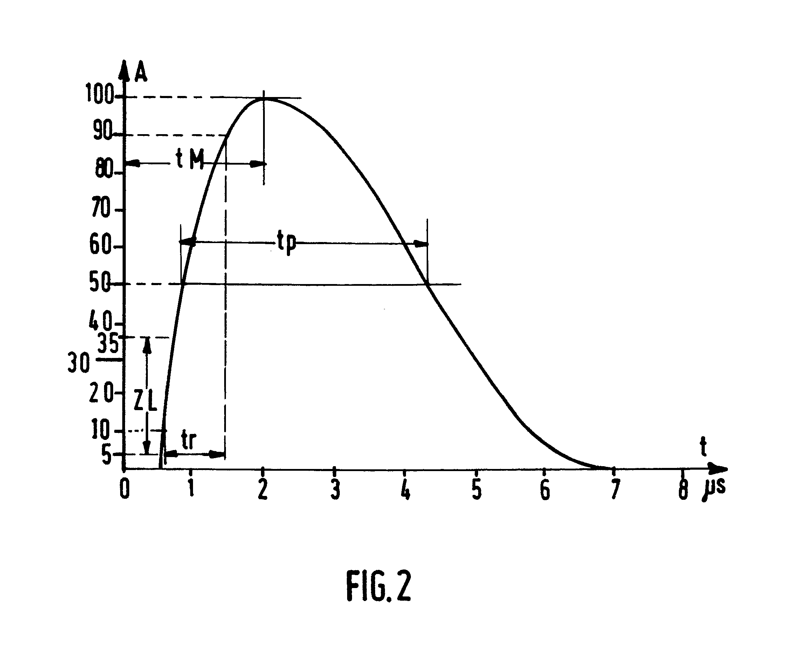

Le dispositif 1 décrit dans cet exemple est destiné à fournir des impulsions convenant pour un système de navigation DME de précision. L'allure du gabarit de l'enveloppe de cette impulsion est montrée à la figure 2 où A représente l'amplitude de l'impulsion et "t" le temps. Cette impulsion se caractérise par un temps de montée $t_r$ compté entre 10 % et 90 % de l'amplitude tel que $t_r < 1,2$ $\mu$s (sur la figure 2, $t_r \sim 0,82$ $\mu$s), une largeur à 50 % tp : tp $\sim 3,5$ $\mu$s et l'on s'impose, en outre, une zone de linéarité ZL entre 5 % et 30 % de l'amplitude. Pour engendrer cette impulsion on utilise un générateur de modulation 15 fournissant ses signaux à l'entrée 10. Bien que le générateur 15 puisse fournir des signaux conformes au gabarit précité, on se heurte aux difficultés apportées par les non-linéarités et par le manque de fidélité de la réponse du générateur de signal 5 au signal appliqué à son entrée de modulation 10.

Dans cet exemple décrit où l'on utilise la tension d'alimentation de l'amplificateur 8 comme tension de modulation, on est confronté à une première difficulté apportée par les seuils de conduction variables entre 10 et 30 V qui sont fonction des transistors utilisés dans cet amplificateur. Autrement dit la forme de l'impulsion émise n'est comparable, à quelques faibles non-linéarités près, à celle de la tension appliquée à l'entrée 10 que lorsque son amplitude est supérieure au seuil de conduction.

Conformément à l'invention pour s'affranchir de ces non-linéarités et de ces problèmes de seuil, le dispositif 1 comporte, tout d'abord, un circuit de réplique 18 pour fournir une réplique de l'impulsion émise ; ce circuit est constitué par un coupleur directionnel 20 couplé à la ligne 12 et un détecteur 22 qui fournit ainsi à la sortie une tension représentant l'enveloppe de l'impulsion émise. Le dispositif 1 comporte en outre un circuit de gestion constitué à partir d'un ensemble à microprocesseur 25 pour comparer cette réplique avec ledit gabarit et pour modifier le signal de modulation du générateur de modulation 15 dans un sens tel que la réplique satisfasse le gabarit.

Le générateur de modulation 15 tel que représenté à la figure 1 est bien adapté aux modifications de son signal de sortie. Le signal de modulation est élaboré tout d'abord sous forme d'échantillons numériques contenus dans une mémoire faisant partie de l'ensemble 25 ; ces échantillons sont ensuite stockés dans une mémoire 27 dite mémoire d'émission munie d'une entrée 28 pour recevoir des échantillons à enregistrer et d'une sortie 29 pour fournir des échantillons à un convertisseur numérique-analogique 30 dont la sortie est connectée à l'entrée de modulation 10 du générateur 5. Les codes d'adresse de lecture de cette mémoire d'émission 27 proviennent d'un compteur 32 comptant les impulsions d'une horloge 34 si un signal MZ appliqué à sa remise à zéro le permet. Ce code transite par un commutateur de code d'adresses dont la position est comandée par un signal WE appliqué aussi à la commande de lecture-écriture de la mémoire d'émission 27. Ainsi pour une première valeur de WE (WE = 1) la mémoire 25 est mise en position de lecture de sorte que l'adresse des échantillons à sa sortie 10 est donnée par le compteur 32, pour une seconde valeur de WE (WE = 0) la mémoire est mise en position d'écriture et l'adresse où est rangé l'échantillon présent à son entrée 28 est donnée par l'ensemble 25 via une ligne commune d'adresse BUSA, l'échantillon à enregistrer provient aussi de l'ensemble 25, mais est transmis par une ligne commune de données BUSD. On voit bien alors qu'il est possible de modifier le signal de modulation par le changement de la valeur de certains échantillons déterminés par l'ensemble 25.

Cet ensemble 25 est composé de la manière la plus conventionnelle, d'un microprocesseur, dans cet exemple le 6809 fabriqué par MOTOROLA, d'une mémoire non volatile à lecture seule (mémoire ROM) pour contenir d'une part le programme de fonctionnement et d'autre part la valeur de certaines constantes telles que les échantillons à emmagasiner dans la mémoire 25 et aussi une mémoire de transit (mémoire RAM). Cet ensemble comporte une entrée IRQ connectée à la sortie d'un générateur d'impulsions d'interruption 38 ; les impulsions fournies par ce générateur 38 sont périodiques et provoquent ainsi périodiquement l'interruption du déroulement d'un programme dit programme principal régissant le fonctionnement de l'ensemble 25 ; ces interruptions correspondent à un passage à un programme dit programme d'interruption ; tout cela sera expliqué dans la suite du présent mémoire.

Compte tenu de la durée de l'impulsion à émettre, on ne prend à la sortie du circuit de réplique 18 que deux valeurs par impulsion : une de ces valeurs est déterminée au moyen d'un compteur d'échantillonnage 40 qui décompte des impulsions élaborées par le circuit d'horloge 34 et dont le signal de passage par zéro agit, par l'intermédiaire d'une bascule "D" 42, sur un interrupteur 44 pour le fermer (un court instant), un circuit de maintien 48 garde la valeur analogique ainsi prélevée ; l'autre valeur correspondant à la valeur crête de l'enveloppe de modulation de l'invention est prélevée dès qu'un interrupteur 46 se ferme pendant un court instant ; cette fermeture survient après un certain temps "tM" déterminé par un circuit monostable 50, compté à partir de l'apparition d'un signal de déclenchement d'émission EMI. Ce certain temps (voir figure 2) correspondant au maximum du signal de modulation, n'a pas besoin d'être déterminé avec précision puisque ce maximum est pratiquement plat. Cette valeur de crête est enregistrée sous forme analogique dans le circuit de maintien 49.

Un convertisseur analogique-numérique 50 est prévu pour convertir les échantillons emmagasinés dans les circuits 48 et 49 ; son entrée peut être mise en relation avec les sorties "sp" et "sc" des circuits 48 et 49 respectivement au moyen d'un commutateur 52 commandé par un signal ICP ; la sortie de ce convertisseur 50 où apparaissent les échantillons numériques est connectée à la ligne BUSD. Mais pour que cet échantillon puisse être validé il faut que le signal NIV soit actif.

Un décodeur d'adresse 54 dont les entrées sont connectées à la ligne BUSA fournit différents signaux : EMI, NIV, LEC, ZEC, FFA et COM. Il a déjà été fait mention des signaux EMI et NIV. Le signal COM est utilisé pour qu'un registre 58 puisse enregistrer des données provenant de la ligne BUSD ; le signal ZEC lorsqu'il est actif met à zéro la bascule 42 ; le signal LEC lorsqu'il est actif provoque le chargement des données provenant de la ligne BUSD dans le compteur 40. On notera que le signal EMI provoque l'émission d'un signal MZ élaboré par un circuit monostable 60 pendant le temps nécessaire à l'émission d'une impulsion. Le signal FFA appliqué à la commande à l'état passant d'un amplificateur à trois états 62, permet de tester la valeur FA représentant la position d'un commutateur 65. La sortie de l'amplificateur 62 est connectée à un fil de la ligne BUSD. Le registre 58 fournit différents signaux ICP, WE et CS dont il a déjà été question.

Le but de l'invention est de fournir l'impulsion selon le gabarit tout en prenant des mesures particulières pour rendre linéaire ladite zone ZL.

Le fonctionnement du dispositif de l'invention est le suivant.

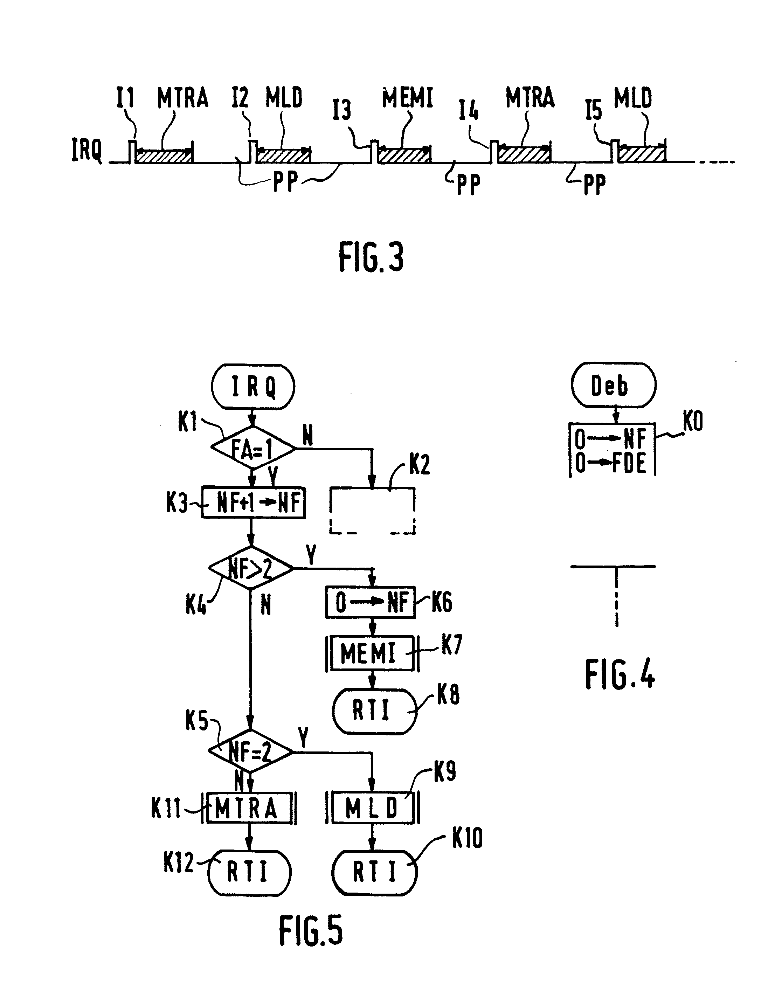

Il est basé sur l'exécution de différents sous-programmes dénommés : "MTRA", "MLD" et "MEMI". Ces sous-programmes sont appelés dès qu'une valeur "1" apparaît à la sortie du générateur 38 ce qui se traduit par des impulsions I1, I2, I3, I4, I5...(voir figure 3). Ces impulsions apparaissent de manière périodique (par exemple toutes les 6,38 ms) et il convient de bien remarquer que ces sous-programmes interviennent toujours dans le même ordre et de manière répétitive. La période de temps qui les sépare doit être suffisante pour permettre l'exécution de ces différents sous-programmes. Les laps de temps restant entre la fin de l'exécution des sous-programmes et l'apparition d'une nouvelle impulsion d'interruption peuvent être consacrés à différentes tâches qui sont exécutées par un programme principal PP et qui ne concernent pas l'invention. Néanmoins, à la mise en route du dispositif de l'invention une de ses tâches consiste à initialiser le contenu de différents emplacements de mémoires participant au fonctionnement du dispositif (voir case K0 à la figure 4). A cette case K0 on met "0" dans les emplacementsmémoires NF et FDE ; on trouvera en annexe la signification des valeurs contenues dans ces différents emplacements de mémoires.

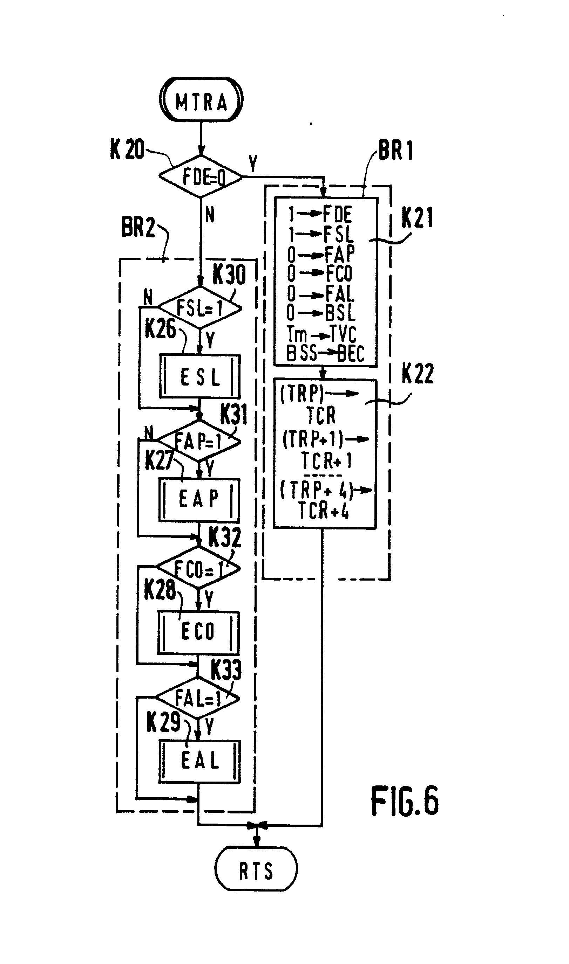

La figure 5 représente un ordinogramme de gestion de ces différentes interruptions. Dès qu'une impulsion d'interruption apparaît on vient tester (case K1) la valeur de FA pour cela on engendre le signal FFA ; si cette valeur n'est pas égale à "1" on va exécuter des tâches qui n'ont rien à voir avec l'invention et donc, n'ont pas à être décrites (case K2). Puis on incrémente d'une unité la valeur NF (case K3) cette valeur va être, ensuite, testée (cases K4 et K5) pour permettre l'exécution ordonnée des différents sous-programmes MTRA, MLD, MEMI. Si la valeur NF est supérieure à 2 (case K4), la valeur NF est mise à "0" (case K6) puis on exécute le sous-programme MEMI (case K7). La fin de l'exécution de ce sous-programme provoque le retour RTI au programme principal (case K8). La valeur NF est testée à nouveau lorsque le test indiqué à la case K4 s'est révélé négatif. Si la valeur NF est égale à "2" on exécute le sous-programme MLD (case K9) puis on retourne au programme principal (case K10). Si le test de la case K5 est négatif on exécute le sous-programme MTRA (case K11) avec ensuite retour au programme principal.

Avant de décrire dans le détail les différents sous-programmes mentionnés, c'est-à-dire : MTRA, MLD et MEMI, on peut en résumer les différentes tâches de la manière suivante :

- Le sous-programme MTRA a pour but de calculer les corrections à apporter pour que l'impulsion émise corresponde au gabarit imposé.
- Le sous-programme MLD a pour but de provoquer le chargement de la mémoire d'émission 27 en fonction des corrections apportées dans le sous-programme MTRA.
- Le sous-programme MEMI a pour but de provoquer la lecture de la mémoire d'émission 27 de façon à moduler correctement l'onde émise par le générateur haute fréquence 5 et de provoquer aussi l'emmagasinage d'une part dans le circuit de maintien 48 d'une valeur de l'impulsion émise dans sa partie à rendre linéaire et d'autre part dans le circuit de maintien 49 de la valeur crête de l'impulsion.

On explique maintenant en détail chacun de ces sous-programmes.

Le sous-programme MTRA (voir ordinogramme de la figure 6) :

Ce sous-programme se décompose essentiellement en deux branches BR1 et BR2. La branche BR1 est exécutée pour FDE = 0 (valeur testée à la case K20), c'est-à-dire après la mise en route du dispositif et la détection de la valeur "1" de FA. Cette branche BR1 est une phase d'initialisation. Cette phase a été, sur la figure 6, décomposée en deux cases : A une première case K21, différentes valeurs sont initialisées c'est-à-dire que l'on met la valeur "1" aux grandeurs FDE, FSL ; la valeur "0" aux grandeurs FAP, FCO, FAL, BSL ; la valeur "Tm" à la grandeur TVC et une valeur "BSS" à la grandeur BEC.

A une deuxième case K22 on vient lire dans un tableau de référence commençant à l'adresse TRP, cinq échantillons d'initialisation représentant l'amplitude de l'impulsion à émettre dans la zone linéaire ZL. Ces cinq échantillons sont rangés dans un autre tableau qui commence à l'adresse TCR. C'est dans ce tableau que sont rangés les échantillons susceptibles d'être corrigés.

Lorsque la valeur FDE n'est pas égale à "0", on passe alors à la branche BR2. Cette branche est constituée par différentes cases (K26, K27, K28 et K29) représentant l'appel à différents sous-programmes "ESL", "EAP", "ECO" et "EAL". Ces derniers sous-programmes ne sont exécutés que si différents tests exécutés sur respectivement les valeurs FSL (K30), FAP (K31) FCO (K32) et FAL (K33) se révèlent positifs, c'est-à-dire égaux à "1". Ces différents sous-programmes seront explicités par la suite.

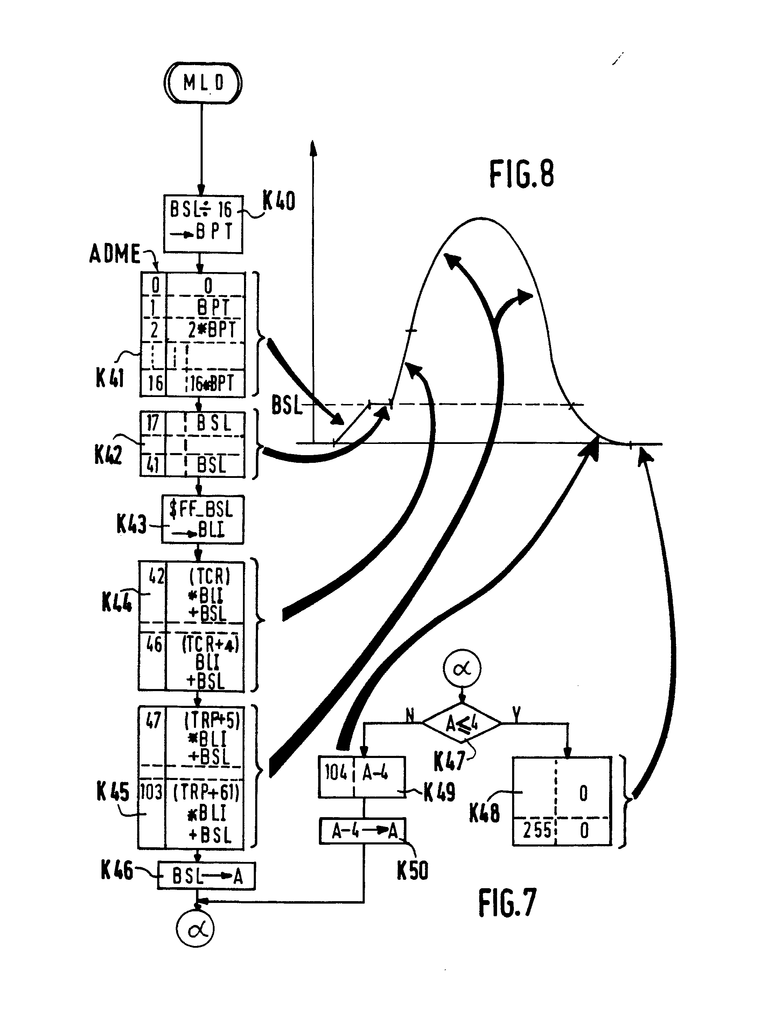

Le sous-programme MLD (voir ordinogramme de la figure 7 associée à la figure 8) :

Ce sous-programme commence par le calcul d'une valeur BPT égale au 1/16 d'une valeur de seuil BSL, cette valeur de seuil correspond, en principe, à la tension qu'il faut appliquer à l'entrée de modulation de l'ampliticateur 10 pour que l'onde émise par le générateur 5 commence juste à être transmise à l'antenne 14. La valeur BPT représente donc la progression pour obtenir la valeur BSL en partant de la valeur nulle. Dans la mémoire d'émission dont le code d'adresses est dénommé ADME, aux adresses ADME allant de 0 à 16 vont être emmagasinés 17 échantillons dont la valeur varie par incréments égaux à BPT pour aller de 0 à 16.BPT (case K41). Aux adresses 17 à 41 on met la valeur BSL (case K42). Puis on calcule la dynamique de l'impulsion à partir de la valeur du seuil ; cette dynamique BLI est telle que : BLI = FF - BSL; le symbolisme FF représente, comme cela est bien connu, la valeur 256 en numération hexadécimale. Puis on traite à la case K44 les cinq échantillons contenus dans le tableau dont l'adresse commence à TCR. On prélève chacun de ces échantillons, on le multiplie par BLI, on ajoute la valeur BSL et on les range respectivement aux adresses ADME 42 à 46. A la case K45 on effectue le même traitement pour les échantillons d'un tableau en mémoire ROM dont l'adresse commence à TRP. Les échantillons ainsi traités sont rangés aux adresses ADME allant de 47 à 103.

Pour éviter une retombée trop brutale de la courbe de modulation due à un seuil trop élevé, on effectue le traitement suivant qui commence à la case K46. La valeur BSL est mise dans le registre A du microprocesseur. Puis on teste cette valeur (case K47) si cette valeur et inférieure ou égale à "4", on met alors la valeur "0" à toutes les adresses restantes ADME jusqu'à la valeur 255 (case K48). Si cette valeur est supérieure à "4" on retranche 4 à la valeur A et cette valeur A - 4 est mise à l'adresse suivante ADME (case K49) puis A - 4 est substituée à A (case K50) et l'on recommence le test indiqué à la case K47 jusqu'à ce que la valeur de A prenne une valeur inférieure ou égale à "4".

La figure 8 représente la courbe de modulation obtenue par ce sous-programme MLD. Les flèches noires allant de l'ordinogramme vers cette courbe indiquent bien la contribution des cases K41, K42, K44, K45, K49 et K48 pour chacune des parties de ces courbes séparées par un petit trait. Pour des raisons de clarté du dessin, cette courbe est représentée d'une manière continue alors qu'en fait elle devrait se présenter en "marches d'escalier".

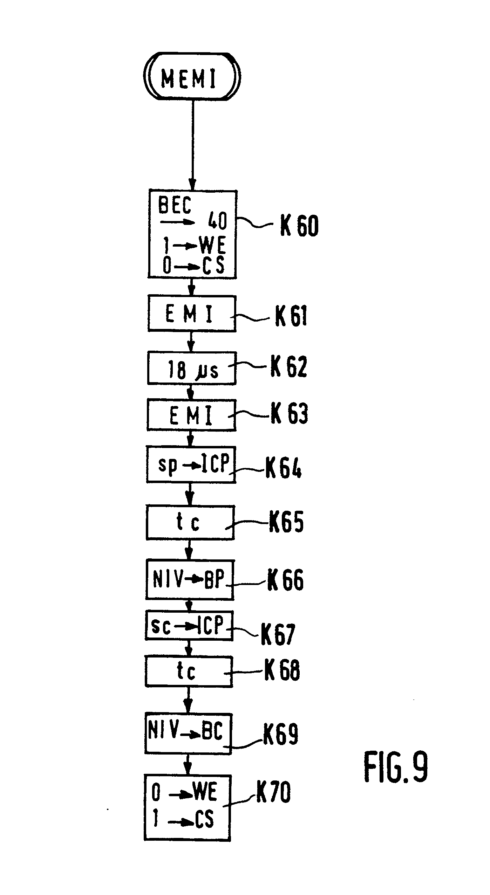

Le sous-programme MEMI (voir ordinogramme de la figure 9) :

Ce sous-programme commence (case K60) : - par la phase de chargement du compteur 40, le contenu de ce compteur devient égal à la valeur BEC ; - par mettre la mémoire d'émission en position lecture (WE = 1) ; - et par sa validation (CS = 0). Puis on engendre sur la ligne BUSA un code qui, reconnu par le décodeur de bus d'adresse, donne une valeur active à EMI (case K61) ce qui déclenche l'émission de la première impulsion ; le compteur d'émission est libéré par le signal MZ à la sortie du circuit monostable 60 ; sans prendre de mesure supplémentaire un échantillon de l'impulsion sera prélevé en fonction du contenu du compteur 40 et emmagasiné dans le circuit de maintien 48 et un échantillon correspondant à la valeur crête dans le circuit de maintien 49.

Puis on laisse passer un laps de temps de 18 s correspondant au mode d'émission (case K62) (exemple mode X FA) avant de déclencher la deuxième impulsion (case K63). Puis on connecte l'entrée du convertisseur analogique-numérique 50 à la sortie "sp" du circuit de maintien 48 et on laisse s'écouler un temps "tc" nécessaire pour que la conversion analogique-numérique puisse s'effectuer (case K65). La valeur convertie est rangée dans une mémoire BP. Pour cela sur la ligne BUSA on engendre un code qui, décodé par le décodeur, fournit une valeur active du signal NIV (case K66). Puis on connecte le convertisseur 50 sur la sortie "sc" du circuit de maintien 49, en engendrant une valeur convenable pour le signal ICP (case K67), puis on attend que la conversion soit effectuée (case K68) et cette valeur et emmagasinée dans une mémoire BC ; puis (case K70) on met la mémoire d'émission en position écriture (WE = 0) et on la déconnecte (CS = 1).

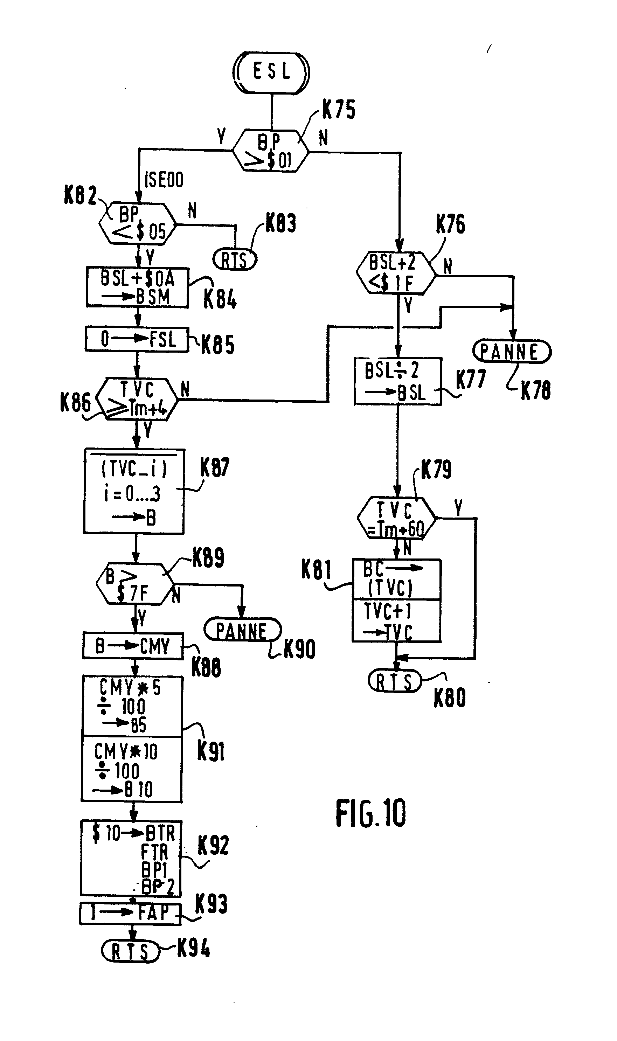

Les sous-programmes faisant partie du sous-programme MTRA :
Sous-programme ESL (voir ordinogramme de la figure 10)

Ce programme commence à la case K76 qui indique un test de la valeur BP. On teste si cette valeur et supérieure à 01 après conversion. On rappelle que cette valeur de BP est obtenue pour une valeur BSS enregistrée dans le compteur 40 (voir case K21) ; cette valeur correspond au début de l'impulsion. Si la valeur est inférieure on passe au test indiqué à la case K76. Avant d'incrémenter de deux la valeur BSL (case K77) on examine donc, à la case K76, si cette valeur est comparable avec une valeur maximum de seuil tolérable, ici 1F. Si le test est négatif on déclare le dispositif en panne (case K78) et aucune autre action n'est entreprise. Une fois la valeur BSL incrémentée on va enregistrer dans le tableau commençant à l'adresse Tm différentes valeurs de crête BC. Pour commencer (case K79) on teste la valeur de TVC, qui constitue le pointeur de ce tableau. Si cette valeur atteint Tm + 60, c'est-à-dire que l'on a enregistré 60 valeurs de crête, on déclare que le sous-programme est terminé case K80. Il faut noter que la prochaine impulsion d'interruption déclenchant le sous-programme MTRA provoquera l'exécution du sous-programme ESL puisque aucun changement n'a été apporté à FSL (voir case K30). Si le test à la case K79 se révèle négatif, on passe à la case K82 où la valeur BC est rangée à l'endroit indiqué par le contenu du pointeur TVC et ce pointeur est incrémenté d'une unité.

On revient au test indiqué à la case K75. Si ce test est positif on effectue un autre test (case K82) sur la valeur BP ; si cette valeur excède la valeur S05, la valeur BP n'est pas considérée et l'exécution du sous-programme ESL est terminée (case K83). Si le test indiqué à la case K82 est positif, on se fixe une valeur de seuil maximum BSM que l'on s'impose à ne plus dépasser par la suite. Cette valeur est BSM = BSL + 0A (case K84). Puis on met à "0" la valeur FSL (case K85) c'est-à-dire que l'on suppose que le but de ce sous-programme ESL a été atteint et ne sera plus exécuté normalement par la suite. On se prépare ensuite à calculer les 5 % et 20 % de la valeur crête avant de vérifier qu'il y a suffisamment d'impulsions enregistrées (au moins 4-case K86) ; pour cela, on teste la valeur du pointeur TVC par rapport à Tm + 4 sinon, il y a un défaut et une panne est symbolisée, on va à la case K78. A la case K87, on indique que l'on effectue le calcul de la valeur moyenne des quatre dernières valeurs de crête BC dont les adresses sont données par le pointeur TVC ; cette valeur calculée est emmagasinée dans le registre B du microprocesseur 6809 précité. Avant de transférer ce contenu de B dans une mémoire baptisée CMY (case K88) on teste (case K89) si cette valeur est comparable avec une valeur prédéterminée : 7F par exemple. Si cette valeur de B est trop faible on estime qu'il y a défaillance et l'on va à la case K90. Puis après le transfert, on calcule (case K91) les valeurs B5 et B10 qui représentent respectivement les 5 % et 10 % de la valeur crête moyenne contenue dans CMY. Puis on initialise (case K92) certaines variables BTR, FTR, BP1, BP2 à 10. A la case K93 on met la valeur "1" à FAP ce qui va autoriser l'exécution du sous-programme EAP à la prochaine interruption déclenchant le sous-programme MTRA. L'exécution du sous-programme ESL est alors terminée case K94.

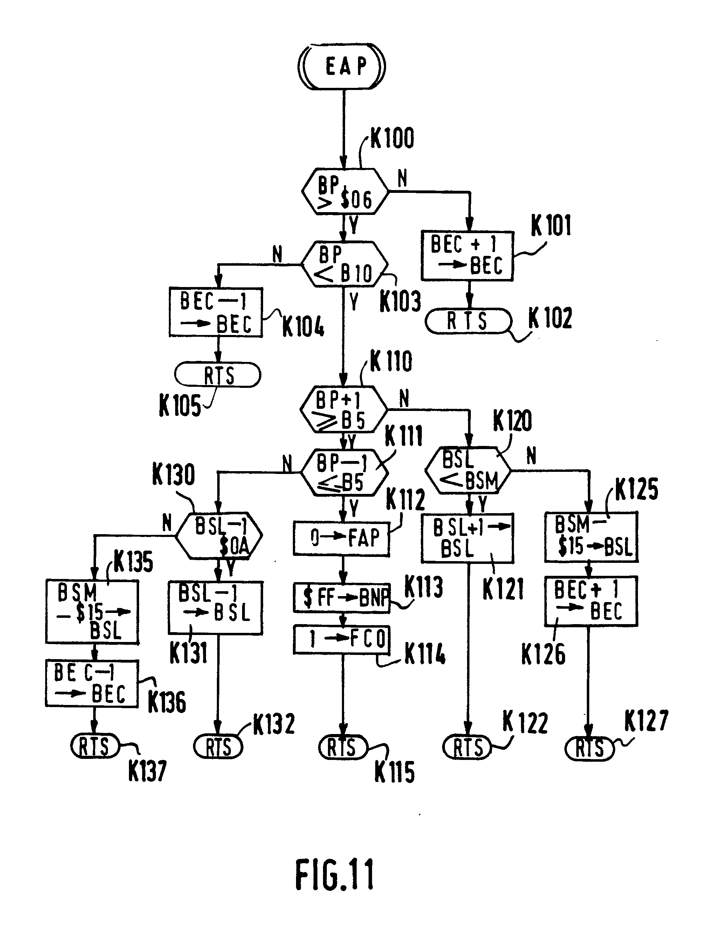

Sous-programme EAP (voir ordinogramme de la figure 11)

Ce sous-programme consiste à déterminer un point correspondant à 5 % de la valeur crête (valeur B5 définie à la case K91 en jouant sur la valeur du temps d'échantillonnage (BEC) et aussi sur la valeur BSL).

Ce sous-programme EAP commence à la case K100 où l'on commence à tester la valeur BP par rapport à une valeur minimum ici 06. Si la valeur BP n'est pas supérieure à 06 on incrémente la valeur BEC d'une unité (case K101) puis le sous-programme s'interrompt (case K102). Si le test indiqué à la case K100 se révèle positif on teste (case K103) la valeur BP par rapport à la valeur B10 ; si cette valeur est trop grande par rapport à B10 on décrémente d'une unité la valeur BEC (case K104) et le sous-programme EAP se termine alors (case K105). Si la valeur BP est inférieure à B10 on cherche alors à obtenir un point BP égal à B5 à ± 1. Pour cela on teste BP + 1 et BP - 1 par rapport à B5 (case K110 et case K111). Si ces deux tests sont satisfaisants on affecte la valeur "0" à FAP (case K112) c'est-à-dire qu'à la prochaine impulsion d'interruption déclenchant le sous-programme MTRA le sous-programme EAP ne sera pas exécuté. Puis on initialise une valeur BNP à FF (case K113) et l'on affecte la valeur "1" à la valeur FCO pour déclencher à la prochaine interruption pour le programme MTRA l'exécution du sous-programme ECO. Le sous-programme EAP est alors terminé (case K115).

Si le test effectué à la case K110 se révèle négatif, on teste (case K120) par rapport à la valeur BSM la valeur BSL. Si celle-ci est inférieure à la valeur que l'on s'est imposé (voir K85) on incrémente d'une unité cette valeur (case K121) et le sous-programme s'arrête là (case K122). Si la valeur BSL n'est pas inférieure à la valeur BSM on recalcule (case K125) une autre valeur de seuil : BSL = BSM - 15 et l'on incrémente la valeur BEC d'une unité (case K126) et le sous-programme se termine (case K127).

Si le test indiqué à la case K111 se révèle négatif on teste (case K130), par rapport à une valeur minimum 0A, par exemple, la valeur BSL diminuée d'une unité ; si cette valeur diminuée est supérieure à cette valeur minimum, cette valeur diminuée se substitue à la valeur BSL (case K131) et le sous-programme se termine (case K132). Si le test indiqué à la case K130 est négatif, on substitue (case K135) la valeur BSM - 15 à la valeur BSL et l'on décrémente d'une unité la valeur BEC (case K136), le sous-programme s'arrête ensuite (case K137).

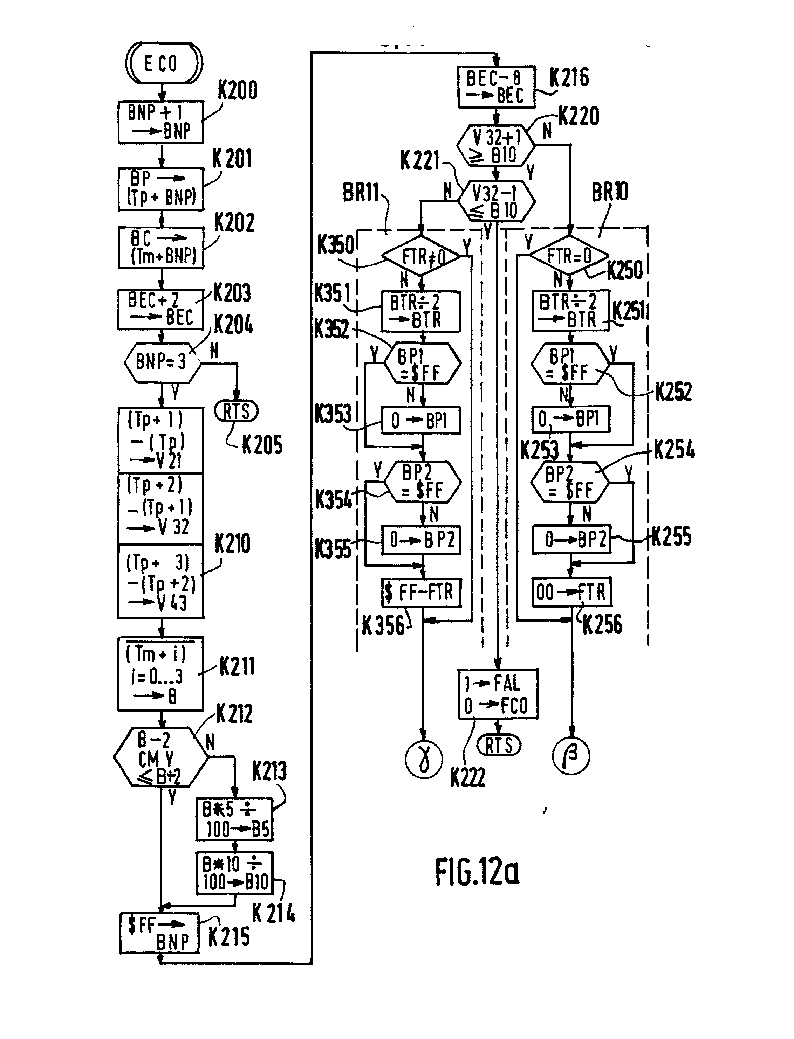

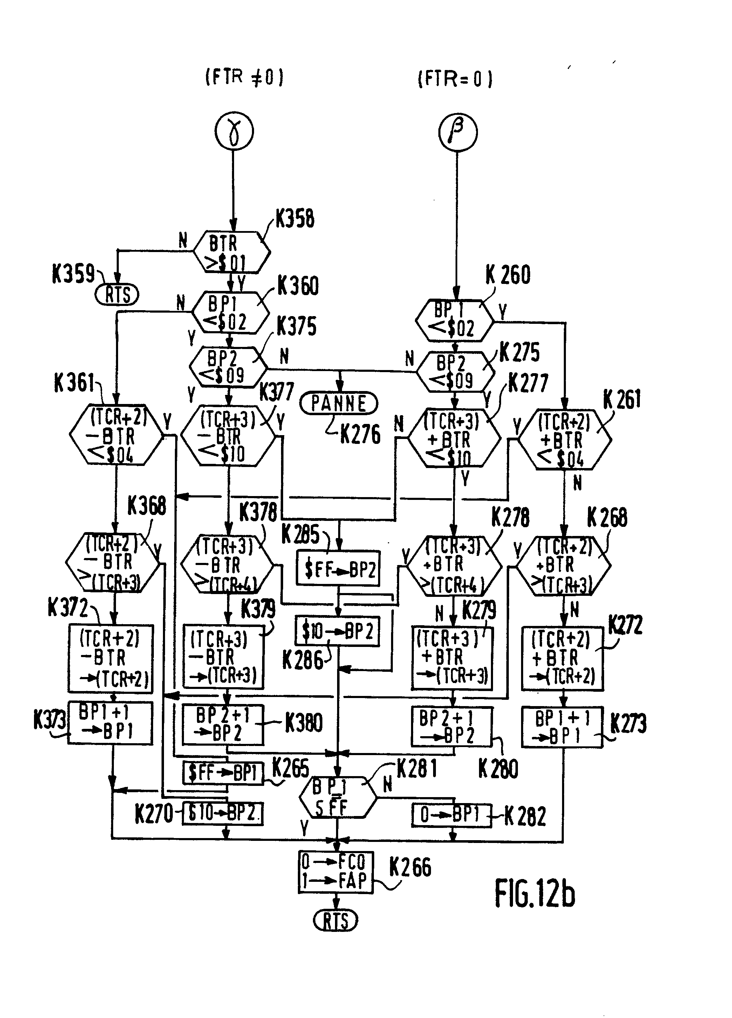

## Sous-programme ECO (voir ordinogramme des figures 12a et 12b)

Ce sous-programme a pour but de ranger les points à 5 %, 15 %, 25 % et 35 %, de ranger aussi la valeur crête correspondant à ces différentes valeurs et d'aligner les points à 15 %, 25 % et 35 %. Ces points vont être rangés dans un tableau dont l'adresse de départ est Tp et la valeur crête mesurée dans le même sous-programme EMI va être rangée dans le tableau dont l'adresse de départ est Tm.

A la case K200 on incrémente d'une unité la valeur BNP qui va servir de pointeur pour ces deux tableaux. On rappelle que cette valeur BNP a été initialisée à FF (case K113) de sorte qu'à cette incrémentation la valeur BNP est "0". Puis on range (case K201) donc, la valeur BP dans le tableau en fonction de la valeur de BNP ainsi que la valeur BC (case K202). Puis on incrémente la valeur BEC de deux unités (case K203) ce qui correspond à un point suivant. Puis on teste la valeur BNP (case K204) pour savoir si l'on a enregistré les quatre points en question, sinon le sous-programme s'interrompt (case K205). Les points sont acquis par l'exécution des sous-programmes MEMI successifs. Si les points sont acquis on calcule alors leurs différences (case K210) soit V21 pour la différence entre les points 15 % et 5 %, V32 pour la différence entre les points 25 % et 15 %, V43 pour la différence entre les points 35 % et 25 %.

Ensuite on calcule la valeur moyenne des valeurs crêtes (case K211) et on la compare (case K212) avec la valeur déjà établie CMY (case K88). Si cette nouvelle valeur n'est pas compatible avec l'ancienne on recalcule les valeurs B5 et B10 (cases K213 et K214). La valeur de BNP est alors réinitialisée à FF (case K215) et la valeur BEC est mise en correspondance avec l'apparition du seuil (case K216). Si le test indiqué à la case K212 est positif on passe directement à la case K215.

On considère ensuite la valeur V32 et on examine par les tests K220 et K221 si cette valeur est égale à ± 1 à la valeur B10. Si on a cette égalité, le sous-programme est terminé et ne sera plus recommencé lors des prochaines impulsions d'interruption déclenchant le sous-programme MTRA ; pour cela on affecte la valeur 1 à FAL et la valeur 0 à FCO (case K222).

Si la valeur V32 augmentée d'une unité est supérieure ou égale à B10 on effectue la branche de programme BR10. Si la valeur V32 diminuée d'une unité est inférieure à B10 on effectue la branche de programme BR11.

Dans la branche de programme BR10 on commence par tester (case K250) la valeur FTR qui donne le sens de la correction à apporter. Si cette valeur est différente de "0" on passe à la case K251 où l'on divise par deux la valeur BTR. Puis on teste (case K252) la valeur BP1 par rapport à FF. Si cette valeur est différente on affecte (case K253) la valeur "0" à BP1 ; puis c'est au tour de la valeur BP2 d'être testée (case K254) par rapport à FF. Si cette valeur est différente on lui impose la valeur "0" (case K256). Ensuite on vient tester la valeur BP1 (case K260 figure 12b). Si cette valeur est inférieure à "2" on teste, avant de le corriger, le point à tester. On teste d'abord (case K261) si ce point, auquel on ajoute la valeur BTR, est inférieur à "4" ; si c'est le cas on passe à la case K265 où l'on affecte la valeur FF à BP1 et de là à la case K266 pour qu'à la prochaine impulsion d'interruption déclenchant le sous-programme MTRA le sous-programme EAP soit à nouveau exécuté. Le point auquel on a ajouté la valeur BTR est ensuite testé (case K268) par rapport au point suivant ; si cette valeur est trop importante, on ne fait aucune correction on affecte la valeur 10 à BP2 (case K270) et l'on passe à la case K266. Si le point auquel on rajoute la valeur

EP 0 209 178 B1

BTR est inférieur à la valeur du point suivant, alors la correction est effectuée (case K272) et l'on incrémente d'une unité la valeur BP1 (case K273).

Si le test indiqué à la case K260 est négatif, on va tester (case K275) la valeur BP2 ; si celle-ci n'est pas inférieure à 09 on va à la case K276 où l'on déclare le dispositif comme étant en panne.

Si le test de la case K275 est positif on va tester (case K277) le point à 35 % (dont l'adresse est TCR + 3) auquel on rajoute la valeur BTR ; si le total est inférieur à 10, on va examiner si cette valeur n'excède pas (case K278) la valeur suivante (adresse TCR + 4). Sinon, la correction est apportée (case K279) et la valeur BP2 incrémentée d'une unité (case K280) ; de là on teste (case K281) la valeur BP1 par rapport à FF ; si cette valeur est différente on réinitialise (case K282) à "0" la valeur BP1 et l'on va à la case K266. Si le test de la case K281 est positif on va directement à la case K266.

Le test indiqué à la case K277 peut être négatif ; on passe alors à la case K285 où affecte la valeur FF à BP1 et l'on passe ensuite à la case K281.

Le test indiqué à la case K278 peut être positif ; on passe alors à la case K286 où l'on affecte la valeur 10 à BP2 et l'on passe ensuite à la case K281.

On revient maintenant à la branche de programme BR11 qui commence par le test (case K350) de la valeur FTR ; si cette valeur n'est pas différente de "0" on effectue les opérations indiquées aux cases K351, K352, K353, K354, K355 et identiques aux opérations indiquées aux cases K251, K252, K253, K254 et K255. Mais à la case K356 qui suit la case K355 on affecte la valeur FF à FTR. Il convient de noter que si les tests effectués aux cases K250 et K350 sont positifs, le programme vient se brancher en aval des cases K256 et K356 respectivement.

L'opération qui suit celle indiquée à la case K356 consiste à tester (case K358) la valeur BTR par rapport à "1". Si BTR n'est pas supérieure à cette valeur, le sous-programme est alors terminé (case K359). Si BTR est supérieure à cette valeur on effectue le test indiqué à la case K360, identique à celui de la case K260. A la case K361 on teste la valeur du point à 15 % (dont l'adresse est TCR + 2) auquel on soustrait la valeur BTR. Le test positif envoie à la case K265 et un test négatif à la case K368 où l'on vient tester ce point soustrait à la valeur suivante ; un test positif envoie à la case K270, un test négatif à la case K372 où cette valeur soustraite est substituée à la précédente (case K372) et la valeur BP1 est incrémentée d'une unité (case K373) et l'on va ensuite à la case K266.

On revient au test indiqué à la case K360, on effectue le test indiqué à la case K375 identique et avec les mêmes implications, s'il se révèle négatif, que celui indiqué à la case K275. Les opérations qui suivent cases K378, K379, K380 sont les mêmes que celles indiquées aux cases K278, K279 et K280 avec la différence, cependant, que la valeur BTR vient se soustraire au lieu de s'ajouter.

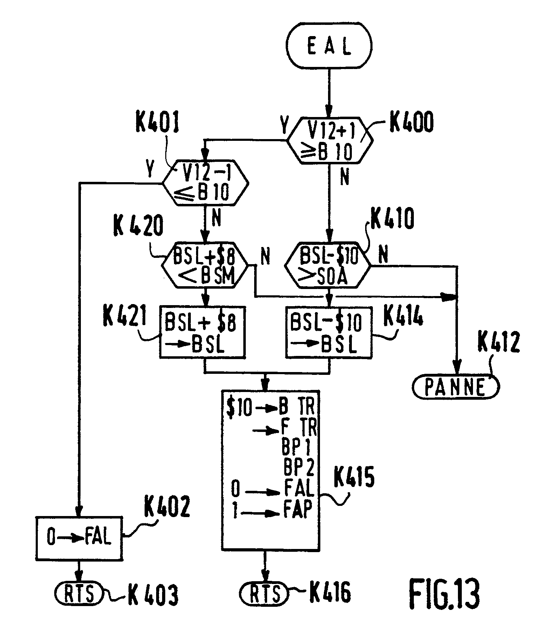

Sous-programme EAL (voir ordinogramme de la figure 13)

On vérifie aux cases K400 et K401 si la grandeur V12 est égale à ± 1 à la valeur B10 ; si c'est vrai, on passe à la case K402 où l'on met à "0" la valeur FAL et l'on peut considérer que le processus de correction conforme à l'invention est achevé (case K403).

Si l'on trouve que la valeur V12 + 1 n'est pas supérieure à B10, on effectue un autre test (case K410) sur la valeur de BSL. On teste si cette valeur diminuée de 10 est supérieure à 0A. Si ce n'est pas le cas, on se déclare en panne (case K412) ; si c'est le cas, c'est la valeur diminuée qui se substitue à BSL (case K414) puis on passe à la case K415 où l'on effectue des initialisations pour le sous-programme EAP qui sera entrepris par la suite avant d'arrêter (case K416) ce sous-programme EAL. Ces initialisations consistent à affecter la valeur 10 à BTR, FTR, BP1, BP2, la valeur "0" à FAL et la valeur "1" à FAP.

Si la valeur V12 - 1 n'est pas inférieure à B10 (case K401) on effectue un autre test sur la valeur BSL (case K420). On augmente la précédente valeur de 8 et on la compare à la valeur préalablement déterminée BSM. Si cette valeur augmentée reste inférieure à BSM, elle se substitue à la valeur BSL (case K421) et l'on passe ensuite à la case K415. Si le test indiqué à la case K420 est négatif on va à la case K412.

ANNEXE

Définition des variables utilisées dans les orginogrammes.

| NOM | SIGNIFICATION |
|------|---------------|
| A | Registre de travail du microprocesseur 6809. |
| ADME | Adresse de la mémoire d'émission. |
| B | Registre de travail du microprocesseur 6809. |
| BEC | Registre du microprocesseur pour charger le compteur d'échantillonnage. |
| BC | Mémoire où est rangé le niveau de la crête de l'impulsion. |
| BLI | BLI = $FF - BSL |
| BNP | Utilisé pour compter le nombre de niveau de point dont le niveau est BP. |
| BP | Mémoire où est rangé le niveau du point échantillonné pour le compteur. |
| BPT | Début de la courbe de modulation (voir figure 8). |
| BSL | Valeur de seuil. |
| BSM | Valeur du seuil maximum à ne pas dépasser. |
| BSS | Valeur à mettre dans le compteur 40 pour obtenir une valeur de seuil. |
| BTR | Valeur de la correction que l'on effectue aux points 25 % ou 35 %. |
| B5 | 5 % de la valeur crête. |
| B10 | 10 % de la valeur crête. |
| BP1 | Nombre de fois que l'on a corrigé le point à 25 %. |
| BP2 | Nombre de fois que l'on a corrigé le point à 35 %. |
| CMY | Valeur de crête moyenne effectuée sur plusieurs valeurs de BC. |

| NOM | SIGNIFICATION |
|-----|---------------|
| EAL | Contrôle de la linéarité du point à 5 % et 15 % par correction de la valeur de seuil ESL. |
| EAP | Sous-programme d'acquisition du point à 5 %. |
| ECO | Sous-programme pour le stockage de 4 points de la zone ZL et du contrôle de la linéarité des points à 25 % et 35 %. |
| EMI | Signal pour provoquer l'émission d'une impulsion. |
| ESL | Sous-programme de détermination de la valeur du seuil. |
| FA | Déterminer la position du commutateur 65. |
| FAL | Indicateur de déclenchement du sous-programme EAL. |
| FAP | Indicateur de déclenchement du sous-programme EAP. |
| FCO | Indicateur de déclenchement du sous-programme ECO. |
| FDE | Variable du démarrage du fonctionnement du dispositif. |
| FSL | Indicateur de déclenchement du sous-programme ESL. |
| FTR | Donne le sens de la correction à apporter. |
| ICP | Connecte l'entrée du convertisseur analogique-numérique 50 sur l'une des sorties sp ou sc de 48 et 49. |
| MEMI | Sous-programme pour lire la mémoire d'émission et mesurer l'impulsion émise. |
| MLD | Sous-programme pour charger la mémoire d'émission 27. |

| NOM | SIGNIFICATION |
|------|---------------|
| MTRA | Sous-programme pour déterminer les corrections à apporter. |
| NIV | Signal de validation du mot de sortie du convertisseur analogique-numérique 50. |
| NF | Numéro d'interruption. |
| sc | Sortie de 49. |
| sp | Sortie de 48. |
| TCR | Adresse de départ d'un tableau où sont rangées les valeurs à corriger. |
| Tm | Adresse de départ du tableau où l'on range la valeur crête BC. |
| Tp | Adresse de départ où l'on range la valeur BP. |
| TRP | Adresse de départ d'un tableau où sont rangés différents échantillons représentant l'amplitude de l'impulsion à émettre. |
| TVC | Valeur de l'adresse où l'on range la valeur crête BC. |

## Revendications

1.  Dispositif pour émettre des impulsions haute fréquence selon un certain gabarit présentant une partie rectiligne, dispositif comportant un générateur de signal haute fréquence (5) muni d'une entrée de commande de modulation (10) pour fournir à sa sortie (12) lesdites impulsions en fonction d'un signal de modulation appliqué à son entrée de modulation (10) et un générateur de modulation (15) pour fournir le signal de modulation l'entrée de modulation, un circuit de réplique (18) pour fournir une réplique de l'impulsion émise, un circuit de gestion (25) pour comparer cette réplique avec ledit gabarit et pour modifier le signal de modulation du générateur de modulation, dans un sens tel que la réplique corresponde au gabarit, dont des valeurs sont emmagasinées dans une mémoire morte, caractérisé en ce que ce circuit de gestion (25) exécute différents traitements pour différentes parties de l'impulsion :
    - un premier traitement consistant à déterminer une valeur de seuil pour obtenir une valeur à appliquer à l'entrée de modulation du générateur de signal haute fréquence telle que celui-ci commence à émettre son énergie,
    - un deuxième traitement consistant à rendre rectiligne une partie de l'impulsion émise correspondant à la partie rectiligne du gabarit par des corrections successives et en tenant compte des fractions de la valeur crête fournie par un détecteur de crête (50, 46) prévu pour mesurer la crête de la réplique,
    - un troisième traitement consistant à raccorder cette partie rectiligne avec le reste de l'impulsion en utilisant des valeurs emmagasinées dans la mémoire et en les corrigeant en fonction de la valeur de seuil,
    - un quatrième traitement consistant à terminer l'impulsion de manière continue.

2.  Dispositif pour émettre des impulsions haute fréquence selon la revendication 1, caractérisé en ce que le générateur de signal haute fréquence est formé d'un oscillateur à haute fréquence (6) suivi d'un amplificateur (8) muni de bornes pour recevoir une tension d'alimentation (10) utilisée comme commande de modulation.

3. Dispositif pour émettre des impulsions haute fréquence selon la revendication 1 ou 2, caractérisé en ce que le générateur de modulation est constitué à partir d'une mémoire d'émission (27) qui est lue pour fournir par l'intermédiaire d'un convertisseur numérique-analogique (30), le signal de modulation (10) et qui est inscrite pour subir les modifications apportées par le circuit de gestion (25).

4. Dispositif pour émettre des impulsions haute fréquence selon la revendication 1 ou 2 ou 3, caractérisé en ce que le circuit de gestion (25) est constitué à partir d'un microprocesseur dont le fonctionnement est régi par programme.

## Claims

1. Device for transmitting high-frequency pulses in a certain pattern that presents a rectilinear part, comprising a high-frequency signal generator (5) which includes a modulation control input (10) for producing at its output (12) said pulses in response to a modulation signal applied to its modulation input (10), and including a modulation generator (15) for supplying pulses to the modulation input, a replica-producing circuit (18) for producing a replica of the transmitted pulse, a management circuit (25) for comparing this replica with said pattern and for modifying the modulation signal coming from the modulation generator in such a way that the replica corresponds to the pattern, values of which pattern are stored in a read only memory, characterized in that this management circuit (25) carries out various processes on different parts of the pulse:
   - first process consisting of determining a threshold value so that a value is obtained which can be applied to the modulation input of the high-frequency signal generator and the latter starts sending out its energy,
   - a second process consisting of making a part of the transmitted pulse that corresponds to the rectilinear part of the pattern also rectilinear by means of successive corrections, and taking fractions of the peak value produced by a peak detector (50,46) into account which are provided for measuring the peak of the replica,
   - a third process consisting of connecting this rectilinear part to the rest of the pulse while making use of the values stored in the memory and correcting them in response to the threshold value,
   - a fourth process consisting of terminating the pulse in a continuous manner.

2. Device for transmitting high-frequency pulsesas claimed in Claim 1, characterized in that the high-frequency signal generator consists of a highfrequency oscillator (6) followed by an amplifier (8) with terminals to receive a supply voltage (10) used as a modulation control.

3. Device for transmitting high-frequency pulses as claimed in Claim 1 or 2, in which the modulation generator is constituted by a transmission memory (27) which is read out to provide a digital-to-analog converter (30), the modulation signal (10) and which is written to undergo the changes made by the management circuit (25).

4. Device for transmitting high-frequency pulsesas claimed in Claim 1, 2 or 3, characterized in that the management circuit (25) is constituted by a program-controlled microprocessor.

## Patentansprüche

1. Einrichtung zum Aussenden von Hochfrequenzimpulsen entsprechend einem bestimmten Muster mit einem geradlinigen Teil, die einen HF-Signalgenerator (5) mit einem Modulationssteuereingang (10) aufweist, zum an dessen Ausgang (12) Liefern der genannten Impulse, abhängig von einem dem Modulationseingang (10) zugeführten Modulationssignal, sowie einen Modulationsgenerator (15) zum Liefern des Modulationssignals zu dem Modulationseingang, weiterhin einen Replikkreis zum Liefern einer Replik des ausgesendeten Impulses, einen Regelkreis (25) zum Vergleichen dieser Replik mit dem genannten Muster und zum Ändern des Modulationssignals des Modulationssignalgenerators, derart, daß die Replik dem Muster, dessen Werte in einem Festwertspeicher gespeichert werden, entspricht, dadurch gekennzeichnet, daß der Regelkreis (25) unterschiedliche Teile des Impulses verschieden behandelt:

- eine erste Behandlung, die daraus besteht, daß ein Schwellenwert bestimmt wird zum Erhalten eines Wertes, der dem Modulationseingang des HF-Generators zugeführt wird, und zwar derart, daß dieser seine Energie auszustrahlen anfängt,
- eine zweite Behandlung, die daraus besteht, daß ein Teil des ausgesendeten Impulses geradlinig gemacht wird, und zwar entsprechend dem geradlinigen Teil des Musters durch aufeinanderfolgende Korrekturen und dadurch, daß Teile des von einem Spitzendetektor (50, 46) gelieferten Spitzenwerte berücksichtigt werden, wobei dieser Detektor dazu vorgesehen ist, die Spitze der Replik zu messen,
- eine dritte Behandlung, die daraus besteht, daß dieser geradlinige Teil mit dem restlichen Teil des Impulses verbunden wird, und zwar unter Benutzung der in dem Speicher gespeicherten Werte und dadurch, daß diese abhängig vom dem Schwellenwert korrigiert werden,
- eine vierte Behandlung, die daraus besteht, daß der Impuls auf kontinuierliche Weise beendet wird.

2. Einrichtung zum Aussenden von Hochfrequenzimpulsen nach Anspruch 1, dadurch gekennzeichnet, daß der HF-Signalgenerator aus einem HF-Oszillator (6) mit einem nachfolgenden Verstärker (8) besteht, der mit Anschlüssen versehen ist zum Erhalten einer Speisespannung (10), die als Modulationssteuersignal benutzt wird.

3. Einrichtung zum Aussenden von Hochfrequenzimpulsen nach Anspruch 1 oder 2, dadurch gekennzeichnet, daß der Modulationsgenerator aufgebaut ist aus einem Sendespeicher (27), der ausgelesen wird um mittels eines Digital-Analog-Wandlers (30) das Modulationssignal (10) zu liefern, und der eingeschrieben wird um die durch den Regelkreis (25) verursachten Änderungen zu erhalten.

4. Einrichtung zum Aussenden von Hochfrequenzimpulsen nach Anspruch 1, 2 oder 3, dadurch gekennzeichnet, daß der Regelkreis (25) aus einem Mikroprozessor besteht, dessen Wirkung programmgesteuert wird.

FIG.1

EP 0 209 178 B1

FIG. 2

FIG.3

FIG.5

FIG.4

FIG.6

FIG.8

MLD

BSL ÷ 16 → BPT  K40

ADME

| 0 | 0 |
|---|---|
| 1 | BPT |
| 2 | 2*BPT |
| ⋮ | ⋮ |
| 16 | 16*BPT |

K41

| 17 | BSL |
|---|---|
| 41 | BSL |

K42

BSL

$FF_BSL → BLI

K43

| 42 | (TCR) *BLI +BSL |
|---|---|
| 46 | (TCR+4) BLI +BSL |

K44

| 47 | (TRP+5) *BLI +BSL |
|---|---|
| 103 | (TRP+61) *BLI +BSL |

K45

BSL → A  K46

α

A ≤ 4  K47

N ────── Y

| 104 | A-4 |  K49

A-4 → A

K50

| | 0 |
|---|---|
| 255 | 0 |

K48

FIG.7

FIG.9

FIG.10

EAP

K100 — BP > $06
K101 — BEC + 1 → BEC
K102 — RTS
K103 — BP < B10
K104 — BEC − 1 → BEC
K105 — RTS
K110 — BP+1 ≥ B5
K111 — BP−1 ≤ B5
K112 — 0 → FAP
K113 — $FF → BNP
K114 — 1 → FC0
K115 — RTS
K120 — BSL < BSM
K121 — BSL+1 → BSL
K122 — RTS
K125 — BSM − $15 → BSL
K126 — BEC + 1 → BEC
K127 — RTS
K130 — BSL − 1 ≤ $0A
K131 — BSL − 1 → BSL
K132 — RTS
K135 — BSM − $15 → BSL
K136 — BEC − 1 → BEC
K137 — RTS

FIG.11

FIG.12a

FIG.12b

EAL

K401

Y        V12+1
         ≥ B 10    K400

Y
V12 −1
≤ B 10
         N

K420              K410

BSL+$8    N    BSL−$10    N
<BSM           >SOA

K421           K414
BSL+ $8        BSL−$10
→BSL           →BSL

K412

PANNE

$10→B TR
    →F TR
      BP 1
      BP 2
0 → FAL    K415
1 → FAP

K402
0 →FAL

RTS  K403        RTS  K416    FIG.13